# EUROPÄISCHE PATENTSCHRIFT

(11) **EP 0 444 618 B1**
(45) Veröffentlichungstag und Bekanntmachung des Hinweises auf die Patenterteilung: **31.05.1995**
(21) Anmeldenummer: 91102830.6
(22) Anmeldetag: 26.02.1991
(51) Int. Cl.: H01J 37/32, H01J 37/18

(54) **Plasma-Behandlungsvorrichtung**
Plasma treatment device
Dispositif de traitement par plasma

(30) Priorität: 26.02.1990 DE 4005956
(43) Veröffentlichungstag der Anmeldung: 04.09.1991
(73) Patentinhaber: Strämke, Siegfried, Dr., D-52538 Selfkant (DE)
(72) Erfinder: Strämke, Siegfried, Dr., D-52538 Selfkant (DE)
(74) Vertreter: Selting, Günther, Dipl.-Ing.

(56) Entgegenhaltungen:
- FR-A- 2 335 614
- US-A- 4 482 419
- US-A- 4 501 766
- Dubbel, Taschenbuch für den Maschinenbau, W. Beitz und K.H. Kütter, Springer Verlag, Berlin, Heidelberg, New York, Tokio, 1986, Seite 432

## Beschreibung

Die Erfindung betrifft eine Plasma-Behandlungsvorrichtung der im Oberbegriff des Patentanspruchs 1 angegebenen Art.

Bei der Plasmabehandlung von Werkstücken wird zwischen dem Werkstück und einer Gegenelektrode eine Glimmentladung im Vakuum erzeugt, wobei bestimmte Gase für die Plasmaerzeugung bei sehr geringem Druck anwesend sind. Dabei wechselwirken Gasatome unter hohen Temperaturen mit der Oberfläche des Werkstücks, um die Oberflächenbeschaffenheit in gewünschter Weise zu verändern. Bekannt sind beispielsweise Verfahren zum Plasma-Aufkohlen, Plasmanitrieren oder Plasmabeschichten von Metallen. Die zu behandelnden Werkstücke werden kalt in einen Ofen eingebracht, durch eine Behandlung bei niedrigem Druck gereinigt, unter zunehmenden Druck aufgeheizt, dann der Plasmabehandlung unterzogen und schließlich abgekühlt.

Eine Plasma-Behandlungsvorrichtung, wie sie in DE-A- 33 22 341 beschrieben ist, weist einen Vakuumbehälter auf, in den das Werkstück eingebracht wird. Das Werkstück wird an eine Elektrode gelegt und der Innenmantel des Vakuumbehälters oder der Behälter selbst wird als Gegenelektrode benutzt. Bei dieser bekannten Vorrichtung, ebenso wie bei anderen Vakuumbehältern für die Glimmentladungsbehandlung von Werkstücken, ist ein kontinuierlicher Durchlaufbetrieb nicht möglich. Die Werkstücke müssen vielmehr chargenweise in den Behandlungsraum eingebracht, behandelt und danach wieder entfernt werden. Es ist nicht möglich, mehrere Werkstücke in der Weise zu bearbeiten, daß sie unterschiedlichen Behandlungsdauern oder Behandlungsarten unterworfen werden. Nach Beendigung einer Behandlung muß zum Werkstückwechsel das Vakuum aufgehoben werden, wobei auch das in der Vakuumkammer vorhandene Gas und die Wärme entweichen. Daß ein kontinuierlicher Betrieb der Vakuumkammer für die Glimmentladungsbehandlung nicht möglich ist, liegt daran, daß die hohen auftretenden Temperaturen in der Größenordnung von 500 bis 2000 °C den Einsatz von Fördereinrichtungen nicht erlauben. Bei den in der Vakuumkammer herrschenden Temperaturen und Entladungsverhältnissen neigen Bauteile, die miteinander in Berührung kommen, zum Verschweißen und zu Erosion. Daher sind bei den bekannten Plasmawärmebehandlungsvorrichtungen sämtliche Teile während der Behandlung feststehend.

Eine Behandlungsvorrichtung mit den im Oberbegriff des Patentanspruchs 1 angegebenen Merkmalen ist bekannt aus US-A- 4 501 766. Diese Vorrichtung weist eine Behandlungskammer auf, in der eine Dreheinrichtung nach Art eines Karussells angeordnet ist. Die Dreheinrichtung trägt ihrerseits mehrere drehbare Werkstückträger, auf die die Werkstücke aufgesetzt werden. Ein Getriebe sorgt dafür, daß bei Rotation der Drehvorrichtung die einzelnen Werkstückträger auf der Dreheinrichtung gedreht werden. Die Behandlungsvorrichtung ist eine mit Hochfrequenzenergie arbeitende Filmablagerungsvorrichtung, bei der die Werkstücke beheizt und an ein elektrisches Potential angeschlossen sind, während ein Kanal, durch den sich die Werkstücke bewegen, mit einer Gegenelektrode verbunden ist. Solche Hochfrequenz-Behandlungseinrichtungen arbeiten mit relativ geringer Temperatur, so daß der Betrieb der Dreheinrichtung und die Drehung der Werkstückträger in Bezug auf die Dreheinrichtung innerhalb der Kammer ohne weiteres möglich sind.

Im Gegensatz zu Behandlungen, die bei relativ niedrigen Betriebstemperaturen stattfinden, erfordern Plasma-Diffusionsverfahren hohe Temperaturen in der Größenordnung von 500 bis 2000 °C. Dabei erfolgt in der Regel die Plasmabehandlung durch gepulste Gleichstromentladung in einer Vakuumkammer. Im Gegensatz zu Beschichtungsverfahren erlauben Plasma-Diffusionsverfahren wegen der Temperatur- und Vakuumbedingungen nicht den Einsatz von Bauteilen, die in reibende Berührung miteinander kommen. Solche Bauteile würden miteinander verschweißt oder zerstört werden.

In Dubbel, Taschenbuch für den Maschinenbau, W. Beitz und K.H. Küttner, Springer-Verlag, Berlin, Heidelberg, New York, Tokio 1986, S. 432, ist eine Lagerkühlung beschrieben. Dabei ist angegeben, daß die Rühlwirkung des Schmierstoffs durch Vergrößerung des Öldurchsatzes verbessert werden kann. Ferner kann durch zweckmäßige Ölführung des austretenden heißen Öls im Gehäuse eines Stehlagers die Wärmeabgabe verbessert werden. Eine zusätzliche Lagerkühlung ist durch den Einbau von öl- oder wasserdurchflossenen Kühlkanälen oder Rohren möglich.

Der Erfindung liegt die Aufgabe zugrunde, eine Plasma-Behandlungsvorrichtung zu schaffen, bei der in derselben Behandlungskammer unterschiedliche Behandlungen, insbesondere unterschiedliche Behandlungsdauern und Temperaturen von Werkstücken durchgeführt werden können und die für Behandlungen, welche relativ hohe Temperaturen erfordern, verwendet werden kann.

Die Lösung dieser Aufgabe erfolgt erfindungsgemäß mit den im Patentantspruch 1 angegebenen Merkmalen.

Bei der erfindungsgemaßen Plasma-Behandlungsvorrichtung ist in der Vakuumkammer eine Dreheinrichtung, hier Drehteller genannt, angeordnet, die vorzugsweise außerhalb der Vakuumkammer gelagert ist. Sämtliche innerhalb der Vakuumkammer, also im Bereich hoher Temperaturen, befindlichen Teile des Drehtellers können starr sein, so daß nicht die Gefahr der Funktionsstörung durch Naterialabtrag oder Verschweißen besteht. Wenn der Drehteller im Inneren der Vakuumkammer gelagert ist, wird das Lager gekühlt. Der Drehteller ist gewissermaßen ein Speicher auf oder an dem mehrere Werkstücke angeordnet werden können. Angrenzend an die Vakuumkammer ist eine Schleuse angeordnet, die das Einbringen und/oder Ausbringen von Werkstücken ermöglicht. Jeder Werkstückplatz des Drehtellers kann in die Übergabeposition zur Schleuse gebracht werden und dann, bei geöffneter Schleusentür, kann das Werkstück in die Schleuse überführt werden. Die erfindungsgemäße Vorrichtung eignet sich besonders für Plasma-Diffusionsbehandlung von Werkstücken, bei denen gepulste Gleichstromentladungen erfolgen. Solche Plasma-Diffusionsbehandlungen erfordern hohe Temperaturen von über 500 °C unter Vakuumbedingungen. Dadurch, daß die Dreheinrichtung außerhalb der Vakuumkammer und der den Wellendurchgang abdichtenden Vakuumdichtung oder unter Kühlung des Lagers im Innern der Vakuumkammer gelagert ist, unterliegt das Lager der Dreheinrichtung nicht den in der Vakuumkammer herrschenden extremen Belastungseinflüssen.

Der Drehteller ist vorzugsweise als Scheibe oder Traggitter ausgebildet, um die Werkstücke daraufstellen zu können. Es ist aber auch möglich, den Drehteller als Gitter, Stern oder Spinne oder als Aufhängevorrichtung auszubilden, d.h. als ein Gestell, an dem die Werkstücke hängend befestigt werden.

Bevor die Schleusentür zwischen Schleuse und Vakuumkammer geöffnet wird, werden in der Schleuse die gleichen Druck- und eventuell auch Gasbedingungen eingestellt wie in der Vakuumkammer. Auf diese Weise kann die Behandlung in der Vakuumkammer auch während und nach dem Öffnen der Schleusentür fortgesetzt werden, ohne daß die Glimmentladungen erlöschen.

Natürlich können außer einzelnen Werkstücken auch ganze Werkstückchargen bearbeitet werden. Das Bewegen der Werkstücke in der Vakuumkammer erfolgt durch den Drehteller. Das Bewegen der Werkstücke zwischen Schleuse und Drehteller erfolgt durch geeignete Handlingvorrichtungen, die zweckmäßigerweise an der Schleuse vorgesehen sind und die nur kurzzeitig den Bedingungen der Vakuumkammer ausgesetzt werden.

Die Erfindung ermöglicht es grundsätzlich, in der Vakuumkammer an allen Stellen im wesentlichen gleiche Bearbeitungsbedingungen herzustellen. Dabei können die Werkstücke nacheinander in die Vakuumkammer eingebracht und nach der jeweils vorgesehnen Behandlungsdauer wieder aus der Vakuumkammer entfernt werden. Es besteht auch die Möglichkeit individuelle Werkstückbearbeitungen vorzunehmen, indem die Temperatur und/oder Dauer und/oder die elektrische Spannung und/oder die Form der Spannung der Glimmentladung individuell gewählt wird. Dies ermöglicht, daß an unterschiedlichen Bearbeitungspositionen innerhalb der Vakuumkammer unterschiedliche Bedingungen geschaffen werden. Um die Bearbeitungspositionen voneinander zu trennen, ist zweckmäßigerweise der Drehteller durch Trennwände in mehrere Räume unterteilt. Jeder dieser Räume kann nun an eine vorgesehene Bearbeitungsposition der Vakuumkammer gebracht werden, wo das in ihm enthaltene Werkstück entsprechend den vorgegebenen Bedingungen individuell bearbeitet wird.

Die Behandlungs-Vorrichtung ist nicht auf die zweidimmensionale Speicherung der Teile auf einem Drehteller beschränkt. Vielmehr können auch mehrere vertikal übereinander angeordnete Drehteller verwendet werden, in die die Werkstücke über eine oder mehrere Schleusen eingelegt werden können. Dabei kann zum Chargieren auch eine axiale Bewegung der Drehteller erfolgen.

Im Gegensatz zu den bisherigen Plasmaverfahren wird der gesamte Prozeß mit konstantem Druck durchgeführt. Die unterschiedlichen Behandlungsschritte, wie Reinigen, Vorbehandlung, Härten, Beschichten, Nachbehandlung werden dabei durch Variation der anderen Prozeßparameter, wie Spannung, Form der Spannung, Temperatur und Atmosphäre erreicht.

Durch die beliebige Positionierungsmöglichkeit der Werkstücke ist zur Energieeinsparung auch eine Verfahrensweise möglich, die eine teilweise Rückgewinnung der in den Teilen gespeicherten Energie ermöglicht. So kann an bestimmten Plätzen beim Aufheizen Wärme aus Wärmespeichern, zum Beispiel Wänden, entnommen werden. Die vorher dort von abkühlenden Teilen eingespeichert wurde.

Insbesondere wenn mehrere Schleusen mit der Vakuumkammer verbunden sind, kann mindestens eine dieser Schleusen auch als Behandlungskammer benutzt werden, in der Reinigungs-, Aufheiz- oder Aufkühlvorgänge durchgeführt werden. Diese Kammern sind mit entsprechenden Handlingeinrichtungen zum Bewegen der Werkstücke versehen.

Im folgenden wird unter Bezugnahme auf die Zeichnungen ein Ausführungsbeispiel der Erfindung näher erläutert.

Es zeigen:

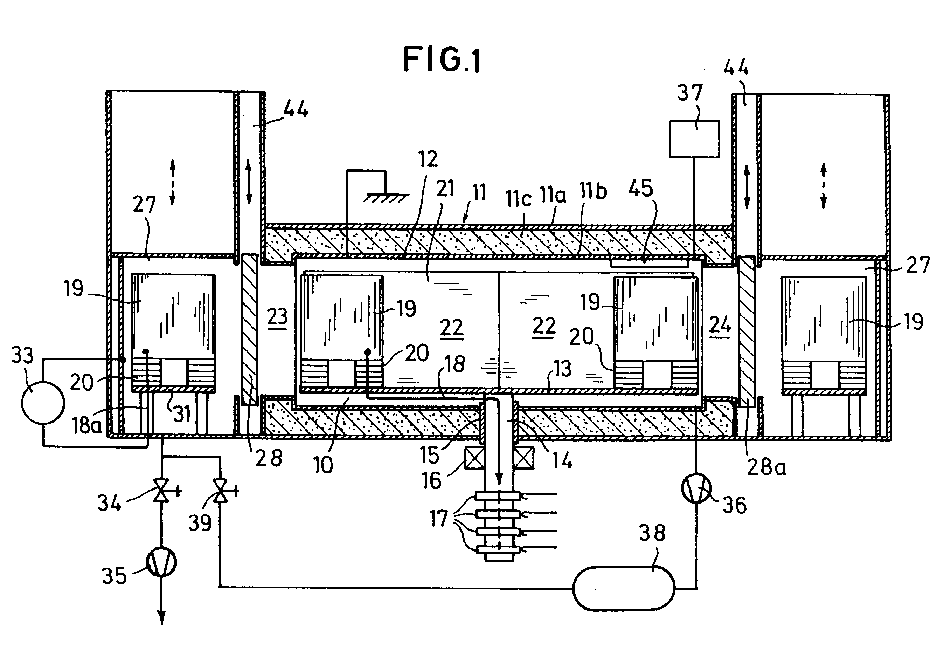

- Fig. 1: einen schematischen Horizontalschnitt durch die Plasma-Behandlungsvorrichtung, und

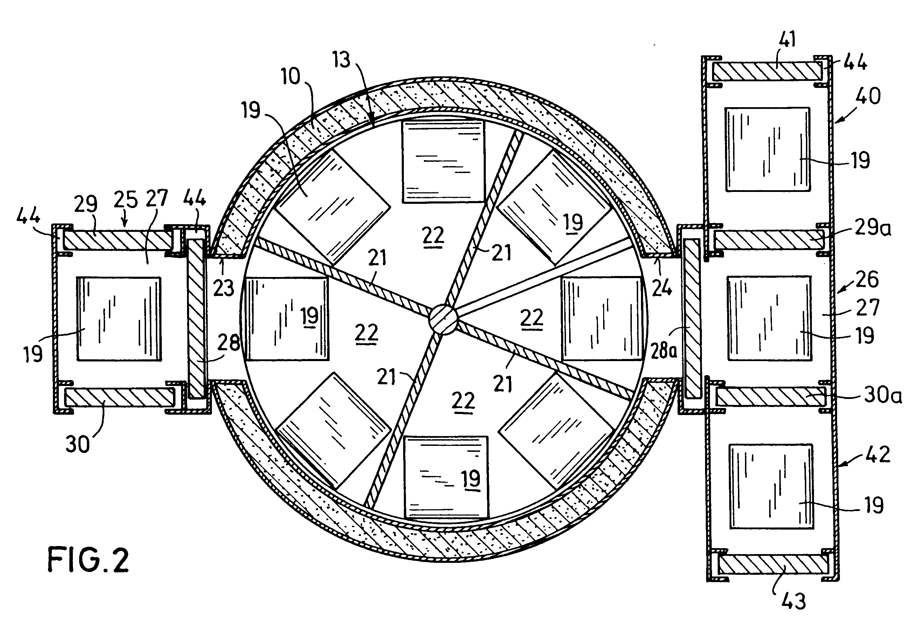

- Fig. 2: eine Draufsicht der Vorrichtung nach Fig. 1.

Die Plasma-Behandlungsvorrichtung weist eine Vakuumkammer 10 auf, die von einem Doppelmantel 11 umschlossen ist. Der Doppelmantel 11 besteht aus einem Außenmantel 11a, einem Innenmantel 11b und der dazwischen befindlichen wärmeisolierenden Schicht 11c. Der Innenmantel 11b bildet zugleich die Gegenelektrode 12, die mit Erdpotential verbunden ist. Die Vakuumkammer 10 ist zylindrisch ausgebildet und in ihr befindet sich der Drehteller 13 mit koaxial zur Kammer der Vakuumachse verlaufender Drehachse. Der Drehteller 13 ist auf dem oberen Ende der Welle 14 befestigt, die durch eine Vakuumdichtung 15 im Boden der Vakuumkammer hindurchführt und außerhalb der Vakuumkammer in einem Lager 16 gelagert ist. Auf der Welle 14 sind Schleifringe 17 angeordnet, die über einzelne Leitungen 18 mit den verschiedenen Werkstückplätzen auf dem Drehteller 13 verbunden sind und die an die Werkstücke 19 elektrisch angeschlossen werden können. Jedes Werkstück 19 steht auf elektrischen Isolatoren 20 auf dem Drehteller 13.

Der Drehteller ist durch Trennwände 21 in mehrere sektorförmige Räume 22 unterteilt. Die Trennwände erstrecken sich bis in die Nähe der Oberwand der Vakuumkammer 22 und in radialer Richtung bis in die Nähe der Seitenwand. In jedem der Räume 22 des Drehtellers 13 befindet sich mindestens ein Werkstückplatz zur Aufnahme eines Werkstücks 19. Die Werkstücke 19 werden in Randnähe des Drehtellers angeordnet.

Unter der Decke der Vakuumkammer 10 sind an den einzelnen Bearbeitungspositionen, unter denen die Werkstückplätze angehalten werden können, Heizvorrichtungen 45 angeordnet. Diese Heizvorrichtungen können aus Heizdrähten bestehen, die Bestandteil der Gegenelektrode 12 sind. Jede der Heizvorrichtungen 45 ist mit mindestens einer elektrischen Leitung verbunden, die durch die Vakuumkammer 10 hindurch herausgeführt ist und an eine separate Heizstromquelle angeschlossen werden kann. Die Heizvorrichtungen 45 sind also separat steuerbar, so daß bei stillstehendem Drehteller 13 die Temperaturen in den einzelnen Räumen 22 getrennt eingestellt und geregelt werden können. Jedem der Räume 22 ist ein Temperaturfühler, z.B. ein Termoelement, zugeordnet, um die Temperatur in diesem Raum zu regeln. Die Meßleitung des Temperaturfühlers ist durch die hohle Welle 14 hindurch herausgeführt.

Im Innern des Doppelmantels 11 ist die Isolierschicht 11c angeordnet. Diese Isolierschicht kann an den einzelnen Bearbeitungstationen unterschiedliche Dämmwerte haben, so daß selbst bei gleichmäßiger Beheizung sämtlicher Bearbeitungspositionen an diesen Bearbeitungspositionen unterschiedliche Temperaturen entstehen. Es ist auch möglich, die Wärmedämmung an den Bearbeitungspositonen jeweils einstellbar zu machen.

An der Umfangswand der Vakuumkammer 10 sind an zwei einander entgegengesetzten Stellen Öffnungen 23,24 vorgesehen, durch die das jeweilige Werkstück 19 hindurchbewegt werden kann. Angrenzend an diese Öffnungen ist jeweils eine Schleuse 25,26 angeordnet, die eine vakuumdichte Kammer 27 aufweist. Zwischen der Kammer 27 und der Vakuumkammer 10 befindet sich eine vertikalbewegbare, vakuumdicht schließende Tür 28. Jede der Kammern 27 hat etwa die Größe eines Werkstückplatzes auf dem Drehteller 13 und dient zur Aufnahme eines Werkstücks 19, das in die Vakuumkammer 10 hinein oder aus dieser heraus umgesetzt werden soll.

Die Schleuse 25 weist ferner zwei weitere vertikalverschiebare Türen 29 und 30 auf, die die Kammer 27 gegen die Umgebung verschließen. In der Kammer 27 befindet sich ein Tisch 31 auf gleicher Höhe wie der Drehteller 13. Dieser Tisch 31 dient zur Aufnahme eines auf Isolatoren 20 stehenden Werkstücks 19. Dieses Werkstück kann mit einer Elektrode 18a verbunden werden, die an eine externe Spannungsquelle 33 angeschlossen ist. Die Innenwand der Kammer 27 ist als Gegenelektrode ausgebildet und an den anderen Pol der Spannungsquelle 33 angeschlossen. Auf diese Weise kann in der Kammer 27 eine Vorbehandlung des Werkstücks 19 durch Glimmentladung erfolgen, bevor dieses Werkstück in die Vakuumkammer 10 hinein umgesetzt wird.

Die Kammer 27 der Schleuse 25 ist ferner über ein Ventil 34 mit einer externen Saugpumpe 35 verbunden, um die Kammer 27 evakuieren zu können.

Die Vakuumkammer 10 ist mit einer externen Saugpumpe 36 zum Evakuieren dieser Vakuumkammer verbunden. Ferner ist die Vakuumkammer 10 an eine Gasquelle 37 angeschlossen, aus der das Behandlungsgas, z.B. Wasserstoff, Stickstoff, Methan oder Argon oder ein Gasgemisch in die Vakuumkammer geleitet wird. Dieses Behandlungsgas wird zur Aufrechterhaltung des Vakuums von der Saugpumpe 36 abgesaugt. Der Druckauslaß der Vakuumpumpe 36 ist mit einem Sammelbehälter 38 verbunden, dessen Auslaß über ein Ventil 39 an die Kammer 27 der Schleuse 25 angeschlossen ist. In dem Sammelbehälter 38 wird das abgesaugte Behandlungsgas unter Druck gesammelt. Dieses Behandlungsgas kann durch das drosselnde Ventil 39 in die Schleuse 25 eingeleitet werden, so daß für die Behandlung in der Schleuse das gleiche Gas benutzt wird, wie in der Vakuumkammer 10. Der Gasdruck in beiden Kammern 10 und 29 kann so geregelt werden, daß er zwischen 0 und 10³ Pa (0 und 10 mbar) beträgt.

Die Schleuse 27 weist ebenfalls eine mit der Öffnung 24 der Vakuumkammer verbundene vakuumdicht schließende Tür 28a und zwei seitliche Türen 29a,30 auf, die jeweils vertikal bewegbar sind. Die Tür 29a führt zu einer Behandlungskammer 40, die eine ins Freie führende weitere Tür 41 aufweist und in der das Werkstück 19 beispielsweise zur Abschreckung einer Luftströmung ausgesetzt wird. Die Tür 30a führt zu einer Behandlungskammer 42, die durch eine weitere Tür 43 mit der Umgebung verbunden ist und in der das Werkstück 19 z.B. einer Wasserbehandlung durch Berieselung zum Härten unterzogen wird.

Sämtliche Türen der Schleusen 25,26 und der Behandlungskammern 40,42 sind in vertikalen Schiebeführungen 44 untergebracht, die die jeweilige Schleuse, bzw. den Behandlungsraum überragen, so daß die Türen vertikal aus den jeweiligen Türöffnungen herausbewegt werden können.

Die beschriebene Plasma-Behandlungsvorrichtung arbeitet wie folgt: Das zu behandelnde Werkstück wird bei geschlossener Tür 28 durch die geöffnete Tür 30 in die Schleuse 25 eingebracht und mit der Elektrode 18a verbunden. Dann wird die Tür 30 verschlossen. Die Kammer 27 wird evakuiert und in diese Kammer wird bei sehr geringem Druck ein Behandlungsgas eingeleitet. Durch Einschalten der Spannungsquelle 33 wird eine Glimmentladung zwischen dem Werkstück 19 und der Gegenelektrode 34 verursacht. Auf diese Weise kann das Werkstück 19 einer oberflächenreinigenden Vorbehandlung im Vakuum unterzogen werden.

Nach Beendigung dieser Vorbehandlung wird die vorhandene Atmosphäre von der Pumpe 35 über das Ventil 34 abgesaugt und über das Ventil 39 so viel Gas aus dem Sammelbehälter 38 eingeleitet, bis Druckgleichgewicht zwischen der Schleuse 29 und der Vakuumkammer 10 herrscht. Danach wird die Tür 28 geöffnet und das Werkstück 19 wird von einem (nicht dargestellten) Manipulator von der Kammer 29 auf den Drehteller 13 in der Vakuumkammer 10 umgesetzt. Danach wird die Tür 28 wieder verschlossen und der Drehteller wird unter Steuerung durch einen Computer so gedreht, daß das Werkstück 19 in eine vorbestimmte Behandlungsposition im Innern der Vakuumkammer 10 gebracht wird, wo es der Wirkung einer Heizvorrichtung 45 ausgesetzt ist und gleichzeitig eine Glimmentladung stattfindet. Das Werkstück ist hierbei an die Elektrode 18 angeschlossen. Danach können andere Bearbeitungsvorgänge unter anderen Betriebsparametern im Innern der Vakuumkammer an unterschiedlichen Bearbeitungspositionen durchgeführt werden. Nach Beendigung der vorgesehenen Bearbeitungsdauer kann das Werkstück entweder durch dieselbe Schleuse 25, durch die es in die Vakuumkammer gelangt ist, aus dieser entfernt werden, oder durch die weitere Schleuse 26 hindurch. Von der weiteren Schleuse 26 kann das Werkstück in eine der Behandlungskammern 40 oder 42 transportiert werden.

In der Vakuumkammer 10 ist die gleiche Behandlung der auf unterschiedlichen Werkstückplätzen des Drehtellers 13 angeordneten Werkstücke möglich, die nach einem vorgegebenen Programm an die verschiedenen Bearbeitungsstationen der Vakuumkammer gebracht werden. Durch die strahlungsabschirmenden Trennwände 21 ist eine gegenseitige Beeinflussung der verschiedenen Behandlungsbedingungen weitgehend ausgeschlossen.

Während des Öffnens der Tür 28 der Schleuse 25 kann die Behandlung im Innern der Vakuumkammer 10 fortgesetzt werden, ohne daß die Gefahr besteht, daß die Glimmentladungen erlöschen oder in Bogenentladungen übergehen. Dies liegt daran, daß in der Schleuse 25 die gleichen Gas-Druck- und Temperaturbedingungen eingestellt werden können, wie in der Vakuumkammer 10. Durch die thermische Trennung der Werkstückplätze im Innern der Vakuumkammer sind individuelle Behandlungsarten der einzelnen Werkstücke möglich. Die Vorrichtung erlaubt eine kontinuierliche Betriebsweise mit unterschiedlichen Behandlungsdauern für die einzelnen Werkstücke. Eine Prozeßsteuerung steuert die Behandlung und den Verbleib der Werkstücke in der Vakuumkammer und in den einzelnen Schleusen.

## Patentansprüche

1. Plasma-Behandlungsvorrichtung mit einer dicht abschließenden Kammer, die mit Werkstücken (19) zu verbindende Elektroden (18) und mindestens eine Gegenelektrode (12) aufweist, einem in der Kammer angeordneten Drehteller (13) mit mehreren Werkstückplätzen, und mindestens einer an die Kammer angrenzenden Schleuse (25), die über eine dicht abschließende erste Tür (28) mit der Kammer und über eine dicht abschließende zweite Tür (30) mit der Umgebung oder einer weiteren Kammer verbunden ist,
**dadurch gekennzeichnet**,
daß die Kammer eine an eine Vakuumpumpe (36) angeschlossene Vakuumkammer (10) ist, die so ausgebildet ist, daß sie zur Durchführung von Hochtemperaturprozessen über 500° C geeignet ist, daß die Welle (14) des Drehtellers außerhalb der Vakuumkammer (10) und der den Wellendurchgang abdichtenden Vakuumdichtung (15) oder unter Kühlung des Lagers im Inneren der Vakuumkammer (10) gelagert ist und daß im übrigen die Vakuumkammer (10) während des Betriebes ausschließlich starre, nicht miteinander in reibende Berührung kommende Teile enthält.

2. Plasma-Behandlungsvorrichtung nach Anspruch 1, dadurch gekennzeichnet, daß die Druckseite einer Saugpumpe (36) zur Aufrechterhaltung des Vakuums in der Vakuumkammer (10) mit einem Einlaß der Schleuse (25) verbindbar ist, um Gas derselben Zusammensetzung wie in der Vakuumkammer (10) in die Schleuse (25) einzuführen.

3. Plasma-Behandlungsvorrichtung nach Anspruch 1 oder 2, dadurch gekennzeichnet, daß die Schleuse (25) an eine eigene Saugpumpe (35) angeschlossen ist.

4. Plasma-Behandlungsvorrichtung nach einem der der Ansprüche 1 bis 3, dadurch gekennzeichnet, daß mehrere Drehteller übereinander angeordnet sind, wodurch eine dreidimensionale Abspeicherung der Werkstücke ermöglicht wird.

5. Plasma-Behandlungsvorrichtung nach Anspruch 4, dadurch gekennzeichnet, daß die einzelnen Abspeicherpositionen durch axiales Verschieben der Drehtelleranordnung erreicht werden.

6. Plasma-Behandlungsvorrichtung nach Anspruch 4, bei der mehrere Abspeicherpositionen durch eine Schleuse erreichbar sind.

7. Plasma-Behandlungsvorrichtung nach einem der Ansprüche 1 bis 6, dadurch gekennzeichnet, daß der Drehteller (13) derart gesteuert ist, daß er nach einem Programm unterschiedliche Drehstellungen einnimmt und in diesen über vorbestimmte Zeit verharrt.

8. Plasma-Behandlungsvorrichtung nach einem der Ansprüche 1 bis 7, dadurch gekennzeichnet, daß der Drehteller (13) durch Trennwände (21) in mehrere Räume (22) unterteilt ist.

9. Plasma-Behandlungsvorrichtung nach Anspruch 8, dadurch gekennzeichnet, daß die Vakuumkammer (10) zylindrisch ist und die Trennwände (21) sich bis zur Kammerumfangswand sowie im wesentlichen in der Höhe bis zur Kammerdecke erstrecken.

10. Plasma-Behandlungsvorrichtung nach einem der Ansprüche 8 oder 9, dadurch gekennzeichnet, daß die Trennwände (21) leitend mit der Wand der Vakuumkammer (10) oder mit einem Werkstück verbunden sind.

11. Plasma-Behandlungsvorrichtung nach einem der Ansprüche 1 bis 10, dadurch gekennzeichnet, daß die Vakuumkammer (10) von zwei Schalen umschlossen ist, von denen die innere die thermische und die äußere die mechanische Belastung aufnimmt.

12. Plasma-Behandlungsvorrichtung nach einem der Ansprüche 1 bis 11, dadurch gekennzeichnet, daß die Wand der Vakuumkammer (10) einen Doppelmantel (11) aufweist, der eine thermische Isolierung (11c) enthält, welcher an unterschiedlichen Arbeitspositionen unterschiedliche Isolierwerte aufweist.

13. Plasma-Behandlungsvorrichtung nach einem der Ansprüche 1 bis 12, dadurch gekennzeichnet, daß in der Vakuumkammer (10) mehrere Heizvorrichtungen (45) oder Kühleinrichtungen an verschiedenen Bearbeitungspositionen angeordnet sind, die separat steuerbar bzw. regelbar sind.

14. Plasma-Behandlungsvorrichtung nach einem der Ansprüche 1 bis 13, dadurch gekennzeichnet, daß die Werkstücke (19) auf oder an dem Drehteller (13) voneinander isoliert angeordnet und jeweils an eine eigene Elektrode (18) angeschlossen sind.

15. Plasma-Behandlungsvorrichtung nach einem der Ansprüche 1 bis 14, dadurch gekennzeichnet, daß die Elektroden (18) mit Schleifringen (17) verbunden sind, die außerhalb der Vakuumkammer (10) an der Welle (14) des Drehtellers (13) vorgesehen sind.

16. Plasma-Behandlungsvorrichtung nach einem der Ansprüche 1 bis 15, dadurch gekennzeichnet, daß unterschiedliche Elektroden mit zugehörigen Stromquellen für verschiedene Werkstücke vorhanden sind.

17. Plasma-Behandlungsvorrichtung nach Anspruch 16, dadurch gekennzeichnet, daß einzelnen Werkstücken separate Temperatur-Regeleinrichtungen zugeordnet sind, welche auf die zugehörige Stromquelle und/oder einen zugehörigen Isoliermechanismus einwirken.

18. Plasma-Behandlungsvorrichtung nach einem der Ansprüche 9-17, dadurch gekennzeichnet, daß in den einzelnen Räumen (22) unterschiedliche Medienkonzentrationen, Medienflüsse oder Prozeßbedingungen einstellbar sind.

19. Plasma-Behandlungsvorrichtung nach einem der Ansprüche 8-18, dadurch gekennzeichnet, daß den einzelnen Räumen (22) eigene Fluidversorgungen und Pumpen zugeordnet sind.

20. Plasma-Behandlungsvorrichtung nach einem der Ansprüche 1 bis 19, dadurch gekennzeichnet, daß die Schleuse (25) eine Elektrode (18a) zum Anschluß eines Werkstücks (19) und eine Gegenelektrode (34) enthält.

21. Plasma-Behandlungsvorrichtung nach einem der Ansprüche 1 bis 20, dadurch gekennzeichnet, daß die Schleuse Einrichtungen zur Behandlung der Werkstücke mit Flüssigkeit und/oder Gas enthält.

22. Plasma-Behandlungsvorrichtung nach einem der Ansprüche 1 bis 21, dadurch gekennzeichnet, daß mindestens eine weitere Schleuse (26) mit der Vakuumkammer (10) verbunden ist.

23. Plasma-Behandlungsvorrichtung nach einem der Ansprüche 1 bis 22, dadurch gekennzeichnet, daß eine Schleuse (26) mit mindestens einer zusätzlichen Behandlungskammer (40,42) verbunden ist.

24. Verfahren zum Betrieb einer Plasma-Behandlungsvorrichtung nach einem der Ansprüche 1 bis 23, dadurch gekennzeichnet, daß die Werkstücke von dem Drehteller mehreren thermisch getrennten Bearbeitungspositionen nacheinander zugeführt werden.

25. Verfahren zum Betrieb einer Plasma-Behandlungsvorrichtung nach einem der Ansprüche 1 bis 23, dadurch gekennzeichnet, daß alle Prozeßschritte in der Vakuumkammer bei gleichem Mediendruck durch Variation von Prozeßparametern wie Spannung, Temperatur oder Atmosphäre durchgeführt werden.

## Claims

1. A plasma treatment apparatus comprising a tightly sealed chamber provided with electrodes (18) to be connected to workpieces (19) and with at least one counterelectrode (12), a rotary plate (13) arranged within said chamber and having a plurality of workpiece places, and at least one sluice (25) arranged adjacent the chamber and connected, via a tightly closeable first door (28), to the chamber, and, via a tightly closeable second door (30), to the environment or a further chamber,
**characterized in**
that said chamber is a vacuum chamber (10) connected to a vacuum pump (36) and adapted to perform high-temperature processes at temperatures higher than 500°C, that the shaft (14) of said rotary plate is supported outside the vacuum chamber (10) and the vacuum sealing means (15) sealing the shaft passage, or, with the bearing being cooled, is supported within the vacuum chamber (10), and that, with the exception thereof, the vacuum chamber (10) during operation comprises exclusively stationary components which do not come into frictional contact with each other.

2. The plasma treatment apparatus according to claim 1, characterized in that the pressure side of a suction pump (36) for maintaining the vacuum in the vacuum chamber (10) is connectable to an inlet opening of the sluice (25), for inserting gas having a composition identical to the gas in the vacuum chamber (10) into the sluice (25).

3. The plasma treatment apparatus according to claim 1 or 2, characterized in that the sluice (25) is connected to an own suction pump (35).

4. The plasma treatment apparatus according to any of claims 1 to 3, characterized in that a plurality of rotary plates are arranged above each other to allow three-dimensional storing of the workpieces.

5. The plasma treatment apparatus according to claim 4, characterized in that said individual storing positions are obtained by axial displacement of the rotary plate arrangement.

6. The plasma treatment apparatus according to claim 4, characterized in that a plurality of storing positions are accessible via one sluice.

7. The plasma treatment apparatus according to any one of claims 1 to 6, characterized in that the rotary plate (13) is controlled, according to a program, to move into different rotary positions and to remain therein for a predetermined period of time.

8. The plasma treatment apparatus according to any one of claims 1 to 7, characterized in that the rotary plate (13) is divided into a plurality of compartments (22) by partition walls (21).

9. The plasma treatment apparatus according to claim 8, characterized in that the vacuum chamber (10) is cylindrical and the partition walls (21) extend to the peripheral wall of the chamber and, in height direction, extend substantially up to the ceiling of the chamber.

10. The plasma treatment apparatus according to claim 8 or 9, characterized in that the partition walls (21) are in conductive communication with the wall of the vacuum chamber (10) or with a workpiece.

11. The plasma treatment apparatus according to any one of claims 1 to 10, characterized in that the vacuum chamber (10) is enclosed by two shells, of which the inner shell takes up the thermal stress and the outer shell takes up the mechanical stress.

12. The plasma treatment apparatus according to any one of claims 1 to 11, characterized in that the wall of the vacuum chamber (10) comprises a double-walled casing (11) including a thermal insulation (11c) having different insulating values at different working positions.

13. The plasma treatment apparatus according to any one of claims 1 to 12, characterized in that the vacuum chamber (10) accommodates a plurality of heating means (45) or cooling means at different treatment positions, to be controlled or regulated separately.

14. The plasma treatment apparatus according to any one of claims 1 to 13, characterized in that the workpieces (19) are arranged on or at the rotary plate (13) while being insulated against each other, and are respectively connected to a dedicated electrode (18).

15. The plasma treatment apparatus according to any one of claims 1 to 14, characterized in that the electrodes (18) are connected to slip rings (17) provided outside the vacuum chamber (10) at the shaft (14) of the rotary plate (13).

16. The plasma treatment apparatus according to any one of claims 1 to 15, characterized in that different-typed electrodes with dedicated power sources are provided for different workpieces.

17. The plasma treatment apparatus according to claim 16, characterized in that individual workpieces have assigned thereto separate temperature-control means acting on the respective power source and/or a respective insulating mechanism.

18. The plasma treatment apparatus according to any one of claims 9 to 17, characterized in that different media concentrations, media flows and process conditions are settable in the individual compartments (22).

19. The plasma treatment apparatus according to any one of claims 8 to 18, characterized in that the individual compartments (22) have assigned thereto individual fluid sources and pumps.

20. The plasma treatment apparatus according to any one of claims 1 to 19, characterized in that the sluice (25) is provided with an electrode (18a) for connection of a work-piece (19) and with a counterelectrode (34).

21. The plasma treatment apparatus according to any one of claims 1 to 20, characterized in that the sluice is provided with means for treating the workpieces with fluid and/or gas.

22. The plasma treatment apparatus according to any one of claims 1 to 21, characterized in that at least one further sluice (26) is connected to the vacuum chamber (10).

23. The plasma treatment apparatus according to any one of claims 1 to 22, characterized in that a sluice (26) is connected to at least one additional treatment chamber (40,42).

24. A method for operating the plasma treatment apparatus according to any one of claims 1 to 23, characterized in that the workpieces are successively supplied from the rotary plate to a plurality of thermally independent treatment positions.

25. A method for operating the plasma treatment apparatus according to any one of claims 1 to 23, characterized in that all of the process steps in the vacuum chamber are carried out at the same media pressure by variation of process parameters, such as voltage, temperature or atmosphere.

## Revendications

1. Dispositif de traitement par plasma, avec une chambre à obturation étanche qui présente des électrodes (18) à connecter à des outils (19) et au moins une contre-électrode (12), un plateau rotatif (13), disposé dans la chambre, avec plusieurs emplacements d'outil, et au moins un sacs (25), adjacent à la chambre, qui est relié, par l'intermédiaire d'une première porte (28) à obturation étanche, avec la chambre et, par l'intermédiaire d'une seconde porte (30) à obturation étanche, avec l'environnement ou une autre chambre,
caractérisé par le fait que la chambre est une chambre à vide (10), raccordée à une pompe à vide (36), qui se présente de façon à être adaptée à la mise en oeuvre de procédés à haute température de plus de 500°C, que l'arbre (14) du plateau rotatif est monté à l'extérieur de la chambre à vide (10) et du joint à vide (15) obturant la passage de l'arbre ou, avec refroidissement du roulement, à l'intérieur de la chambre à vide (10) et que, par ailleurs, la chambre à vide (10) ne comporte, pendant le fonctionnement, qu'exclusivement des pièces rigides n'entrant pas en en contact de friction l'une avec l'autre.

2. Dispositif de traitement par plasma selon la revendication 1, caractérisé par le fait que le côté de pression d'une pompe d'aspiration (36) est susceptible, pour maintenir le vide dans la chambre à vide (10), d'être raccordé à une entrée du sas (25), afin d'alimenter le sas (25) avec un gaz de même composition que celui dans la chambre à vide (10).

3. Dispositif de traitement par plasma selon la revendication 1 ou 2, caractérisé par le fait que le sas (25) est raccordé à une pompe d'aspiration (35) qui lui est propre.

4. Dispositif de traitement par plasma selon l'une des revendication 1 à 3, caractérisé par le fait que plusieurs plateaux rotatifs sont disposés l'un au-dessus de l'autre, ce qui rend possible un entreposage tridimensionnel des outils.

5. Dispositif de traitement par plasma selon la revendication 4, caractérisé par le fait que les emplacements d'entreposage individuels sont atteints par déplacement axial de l'arrangement du plateau rotatif.

6. Dispositif de traitement par plasma selon la revendication 4, caractérisé par le fait que plusieurs emplacements d'entreposage sont accessibles à travers un sas.

7. Dispositif de traitement par plasma selon l'une des revendications 1 à 6, caractérisé par le fait que le plateau rotatif (13) est commandé de telle sorte qu'il occupe, selon un programme, des positions de rotation différentes et reste dans celles-ci pendant un temps prédéterminé.

8. Dispositif de traitement par plasma selon l'une des revendications 1 à 7, caractérisé par le fait que le plateau rotatif (13) est subdivisé en plusieurs espaces (22) par des cloisons (21).

9. Dispositif de traitement par plasma selon la revendication 8, caractérisé par le fait que la chambre à vide (10) est cylindrique et que les cloisons (21) s'étendent jusqu'à la paroi périphérique de la chambre ainsi que, en hauteur, sensiblement jusqu'au plafond de la chambre.

10. Dispositif de traitement par plasma selon l'une des revendications 8 ou 9, caractérisé par le fait que les cloisons (21) sont reliées de manière conductrice à la paroi de la chambre à vide (10) ou à un outil.

11. Dispositif de traitement par plasma selon l'une des revendications 1 à 10, caractérisé par le fait que la chambre à vide (10) est entourée de deux coquilles dont l'intérieure absorbe la sollicitation thermique et l'extérieure la sollicitation mécanique.

12. Dispositif de traitement par plasma selon l'une des revendications 1 à 11, caractérisé par le fait que la paroi de la chambre à vide (10) présente une double enveloppe (11) qui contient une isolation thermique (11c) qui, à des emplacements de travail différents, présente des valeurs d'isolation différentes.

13. Dispositif de traitement par plasma selon l'une des revendications 1 à 12, caractérisé par le fait que dans la chambre à vide (10) sont disposés, à des emplacements d'usinage différents, plusieurs dispositifs de chauffage (45) ou dispositifs de refroidissement qui peuvent être commandés ou réglés séparément.

14. Dispositif de traitement par plasma selon l'une des revendications 1 à 13, caractérisé par le fait que les pièces à usiner (19) sont disposés sur ou contre le plateau rotatif (13), isolées l'une de l'autre, et raccordées, chacune, à une électrode (18), qui lui est propre.

15. Dispositif de traitement par plasma selon l'une des revendications 1 à 14, caractérisé par le fait que les électrodes (18) sont reliées à des bagues collectrices (17) qui sont prévues à l'extérieur de la chambre à vide (10), sur l'arbre (14) du plateau rotatif (13).

16. Dispositif de traitement par plasma selon l'une des revendications 1 à 15, caractérisé par le fait qu'il est prévu, pour différentes pièces à usiner, des électrodes différentes à sources de courant associées.

17. Dispositif de traitement par plasma selon la revendication 16, caractérisé par le fait qu'aux différentes pièces à usiner sont associées des dispositifs de réglage de température séparés, qui agissent sur la source de courant correspondante et/ou un mécanisme d'isolement correspondant.

18. Dispositif de traitement par plasma selon l'une des revendications 9 à 17, caractérisé par le fait que dans les différents espaces (22) peuvent être réglés des concentrations de fluide, des débits de fluide ou des conditions de procédé différents.

19. Dispositif de traitement par plasma selon l'une des revendications 8 à 18, caractérisé par le fait qu'aux différents espaces (22) sont associées des alimentations de fluide et des pompes, qui leur sont propres.

20. Dispositif de traitement par plasma selon l'une des revendications 1 à 19, caractérisé par le fait que le sas (25) comporte une électrode (18a) pour la connexion d'une pièce à usiner (19) et une contre-électrode (34).

21. Dispositif de traitement par plasma selon l'une des revendications 1 à 20, caractérisé par le fait que le sas comporte des dispositifs pour le traitement des pièces à usiner par un liquide et/ou un gas.

22. Dispositif de traitement par plasma selon l'une des revendications 1 à 21, caractérisé par le fait qu'au moins un autre sas (26) est relié à la chambre à vide (10).

23. Dispositif de traitement par plasma selon l'une des revendications 1 à 22, caractérisé par le fait qu'un sas (26) est relié à au moins une chambre de traitement (40, 42) supplémentaire.

24. Procédé pour faire fonctionner un dispositif de traitement par plasma selon l'une des revendications 1 à 23, caractérisé par le fait que les pièces à usiner sont amenées par le plateau rotatif successivement à plusieurs emplacements d'usinage thermiquement séparés.

25. Procédé pour faire fonctionner un dispositif de traitement par plasma selon l'une des revendications 1 à 23, caractérisé par le fait que toutes les étapes de procédé sont réalisées dans la chambre à vide à la même pression de fluide par variation des paramètres du procédé, tels que la tension, la température ou l'atmosphère.
